# EUROPÄISCHE PATENTSCHRIFT

(11) **EP 2 327 150 B1**
(45) Veröffentlichungstag und Bekanntmachung des Hinweises auf die Patenterteilung: **27.11.2013**
(21) Anmeldenummer: 09741199.5
(22) Anmeldetag: 10.09.2009
(51) Int. Cl.: H03F 1/32

(54) **VORVERZERRUNGSLINEARISIERER IN BRÜCKENTOPOLOGIE MIT EINER EQUALIZERSTUFE JE BRÜCKENZWEIG**
PREDISTORTION LINEARIZER WITH BRIDGE TOPOLOGY HAVING AN EQUALIZER STAGE FOR EACH BRIDGE ARM
LINÉARISEUR À PRÉDISTORSION DANS LA TOPOLOGIE DES PONTS AVEC UN ÉTAGE ÉGALISEUR PAR BRANCHE DE PONT

(30) Priorität: 10.09.2008 DE 102008046689
(43) Veröffentlichungstag der Anmeldung: 01.06.2011
(73) Patentinhaber: Tesat-Spacecom GmbH & Co. KG, 71522 Backnang (DE)
(72) Erfinder: KHILLA, Abdel-Messiah, 71522 Backnang (DE); LEUCHT, Detlef, 71540 Murrhardt (DE); GROSS, Walter, 71522 Backnang (DE); JUTZI, Michael, 71522 Backnang (DE); SCHREIBER, Hartmut, 74427 Fichtenberg (DE)
(74) Vertreter: Avenhaus, Beate
(86) Internationale Anmeldenummer: PCT/DE2009/001263
(87) Internationale Veröffentlichungsnummer: WO 2010/028635

(56) Entgegenhaltungen:
- EP-A1- 1 098 435
- WO-A1-2008/144231
- US-A- 4 878 030
- US-A- 5 428 314

## Beschreibung

### Stand der Technik

Die Erfindung betrifft einen Vorverzerrungslinearisierer für Leistungsverstärker unter Verwendung einer Brückentopologie.

Nachrichtentechnische Nutzlasten von Raumfahrtgeräten sollen bei möglichst kleiner Gerätemasse große Informationsmengen übertragen können. Da neuartige, effiziente Modulationsverfahren und Mehrträgerverfahren zunehmend große Bandbreiten erfordern, sind breitbandige Linearisierer wichtige Bausteine für Sendeeinheiten, die für Trägerfrequenzen und verschiedenste Modulationsverfahren transparent sind.

Leistungverstärker weisen ein nichtlineares Verhalten auf, das in einem Fertigungslos unterschiedlich ausfällt und stark von der Frequenz abhängt. Linearisiererbrücken nach dem derzeitigen Stand der Technik erlauben lediglich eine Anpassung ihrer nichtlinearen Kompensation für einen Teil der Betriebsfrequenzbandbreite, für die übrigen Frequenzen innerhalb des Nutzbandes hingegen entspricht die Linearisierung nicht dem geforderten Verlauf.

Eine Linearisiererbrücke beruht auf der vektoriellen Addition eines linearen, d.h. leistungsunabhängigen, und eines nichtlinearen, d.h. eines verzerrungsbehafteten Signals. Die vektorielle Aufteilung und Addition der Signale der beiden Zweige findet z.B. in 90°-Hybriden am Eingang bzw. Ausgang der Schaltung statt.

Im nichtlinearen Zweig durchläuft das Signal zunächst den Verzerrungsgenerator. Mit zunehmender Signalleistung weicht das Signal am Verzerrungsgeneratorausgang in Amplitude und Phase vom Kleinsignalverhalten ab. Dabei erfährt meistens sowohl die Amplitude als auch die Phase eine Kompression. Mit einem einstellbaren Phasenschieber beispielsweise im linearen Zweig oder in beiden Zweigen kann bei Kleinsignalaussteuerung die erforderliche relative Phasenverschiebung zwischen linearem und nichtlinearem Zweig eingestellt werden.

Im nichtlinearen Zweig oder in beiden Zweigen erlaubt ein einstellbares Dämpfungsglied die Einstellung einer relativen Dämpfung zwischen nichtlinearem und linearem Zweig.

Bei Frequenzen im zweistelligen GHz-Bereich hängt das nichtlineare Verhalten von Leistungsverstärkern stark von der Frequenz ab. Parasitäre Effekte innerhalb der Linearisiererbrücke erschweren die Kontrolle des Frequenzgangs des Linearisierers. Im Prinzip ist ein Abgleich auf die gewünschten Eigenschaften nur in einem eingeschränkten Frequenzbereich möglich.

In der DE 195 28 844 C1 wird ein "Verfahren und Vorrichtung zur Linearisierung der Verstärkungs- und Phasengänge von Wanderfeldröhren und Halbleiterverstärkern bei unterschiedlichen Leistungspegeln" offenbart. Dabei wird das Signal auf zwei Zweige aufgeteilt und wieder zu einem Ausgangssignal zusammengefügt, wobei das Signal auf zwei nichtlineare Teilnetzwerke mit komprimierendem Verstärkungsverhalten aufgeteilt wird und durch entsprechend dem Signalpegel unterschiedlichen Reflexionsverhalten an zwei Toren eine Verstärkungskompression bzw. eine Verstärkungsexpansion der Teilsignale erzeugt. Dabei wird das nichtlineare, verstärkungsexpandierte Signal und das verstärkungskomprimierte Singal mit einem addierenden Netzwerk zum Ausgangssignal zusammengefügt.

Ebenfalls bekannt ist ein "Rundfunkübertragungssystem mit verteilter Korrektur" (DE 600 06 102 T2) zur Kompensation von Verzerrungen in einem digitalen Übertragungssystem. Dabei wird ein Übertragungssystem mit einem Signalweg bereitgestellt, wobei eine erste Komponente einer Vielzahl von Komponenten, die sich im Signalweg befinden, das Informationssignal nichtlinearen Verzerrungsverschiebungen unterwirft, und eine weitere Vielzahl von Komponenten aus dritten und vierten - Komponenten der Modifizierung des Informationssignals dienen, um die Verzerrungen in einer inversen Reihenfolge zu der ersten Vielzahl von Komponenten zu kompensieren. Dabei weist die erste Komponente einen Leistungsverstärker, die zweite ein Vorverzerrungsfilter, die dritte Komponente einen nichtlinearen Korrigierer und die vierte Komponente einen linearen Entzerrer auf. Die fünfte Komponente umfasst einen Filter und die sechste einen zweiten linearen Entzerrer.

Weiters wird in EP 1028435 ein Linearisierer offenbart, bei dem sich in einem Zweig ein Equalizer befindet und welcher einen zweiten Equalizer nach der Kombination der Signale in den zweigen aufweist.

### Die Erfindung und ihre Vorteile

Die Erfindung gemäß den Merkmalen des Hauptanspruchs hat dahingegen den Vorteil, dass im linearen und nichtlinearen Brückenzweig eine Equalizerstufe angeordnet ist. Diese Equalizerstufe dient dem Abgleich des Frequenzgangs der komplexen Expansion der Brücke. Die Equalizerstufen im linearen und nichtlinearen Brückenzweig fügen einen genau definierten Amplituden- und Phasengang ein, der parasitäre Effekte z.B. durch Streukapazitäten und Bondinduktivitäten kompensiert und breitbandig zur gewünschten Expansion hinsichtlich Amplitude und Phase am Ausgang der Linearisiererschaltung führt.

Die Equalizer fügen einstellbare Überfragungsfunktionen in den linearen und nichtlinearen Brückenzweig ein, so dass der Linearisierer den individuellen, innerhalb eines Fertigungsloses variierenden nichtlinearen Frequenzgang eines Leistungsverstärkers kompensiert. So kann beispielsweise eine über der Frequenz ansteigende Phasenexpansion bei konstanter Amplitudenexpansion eingestellt werden. Ebenso ist aber z.B. auch eine über der Frequenz ansteigende Amplitudenexpansion bei gleichzeitig zunehmender Phasenkompression erreichbar. Die Equalizerstufe erlaubt somit den präzisen Abgleich der Brücke auf die Charakteristik des Leistungsverstärkers.

Nach einer vorteilhaften Ausgestaltung der Erfindung kann die Equalizerstufe sowohl als passive Schaltung als auch einstellbar mit aktiven Elementen wie z. B. Dioden und Transistoren realisiert werden.

Der Equalizerblock in dieser erfindungsgemäßen Ausgestaltung ist entscheidend für die Realisierung großer Nutzbandbreiten, die aus Kosten- und im Raumfahrtbereich aus Gewichts- und Redundanzgründen erwünscht sind.

Weitere Vorteile und vorteilhafte Ausgestaltungen der Erfindung sind der nachfolgenden Beschreibung, der Zeichnung und den Ansprüchen entnehmbar.

### Zeichnung

Fig. 1 zeigt ein Blockschaltbild der Linearisiererbrücke gemäß dem Stand der Technik.
In Fig. 2 ist die Addition der Signalvektoren gem. dem St. d. T. dargestellt.
Fig. 3 zeigt die Isokonturlinien der Übertragungsfunktion nach Betrag und Phase gem. St. d. T.
In Fig. 4 ist der Betrag der Übertragungsfunktion des Linearisierers als Funktion der Eingangsleistung gem. St. d. T.
Fig. 5 zeigt die Phase der Übertragungsfunktion des Linearisierers als Funktion der Eingangsleistung gem. St. d. T.
Fig. 6 zeigt das Blockschaltbild der Linearisiererbrücke gem. der Erfindung.
In Fig. 7 ist der Frequenzgang der Amplituden- und Phasenexpansion der Linearisiererbrücke bei maximaler Eingangsleistung dargestellt.
Fig. 8 zeigt das Blockschaltbild der Linearisiererbrücke gem. Erfindung in einer symmetrischen Ausgestaltung

### Beschreibung der Ausführungsbeispiele

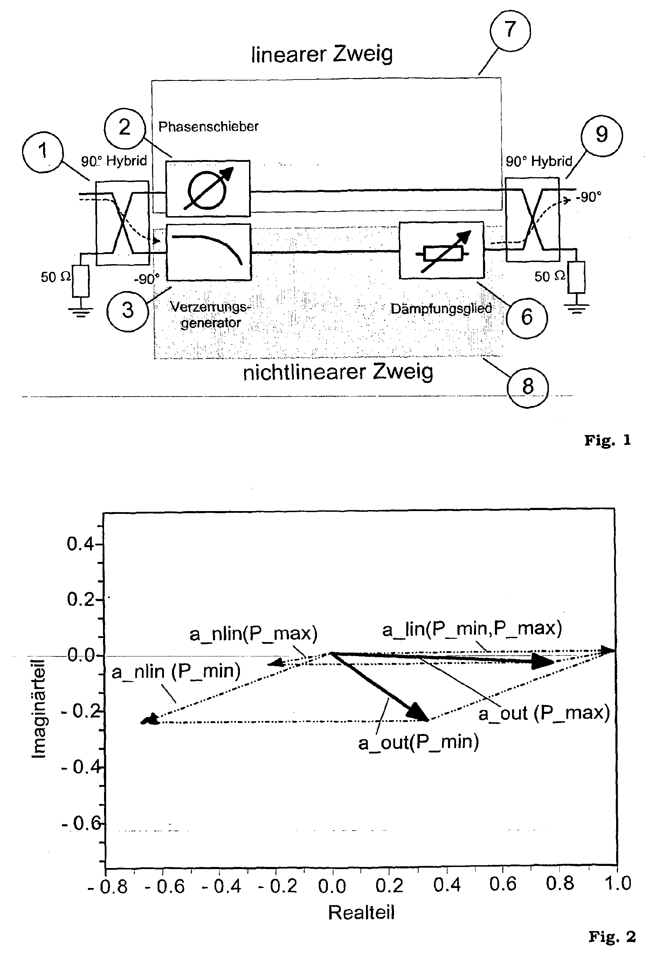

Fig. 1 zeigt ein Blockschaltbild der Linearisiererbrücke gem. dem St .d. T. mit dem 90°-Hybrid 1 am Eingang, dem Phasenschieber 2 sowie dem 90°-Hybrid 9 am Ausgang der Schaltung. Dabei findet die vektorielle Addition des linearen, d. h. leistungsabhängigen Signals statt. Desweiteren ist im nichtlinearen, d. h. verzerrungsbehafteten Signal, ein Verzerrungsgenerator 3 sowie ein Dämpfungsglied 6 zwischengeschaltet.

Im nichtlinearen Zweig durchläuft dabei das Signal zunächst den Verzerrungsgenerator 3. Mit zunehmender Signalleistung weicht dabei das Signal am Verzerrungsgeneratorausgang in Amplitude und Phase vom Kleinsignalverhalten ab. Die Amplitude erfährt dabei meistens eine Kompression wie in Fig. 1 angedeutet. Mit einem einstellbaren Phasenschieber 2 im linearen Zweig kann bei Kleirisignalaussteuerung die erforderliche Laufzeitdifferenz zwischen beiden Zeigen erreicht werden.

Im nichtlinearen Zweig erlaubt ein einstellbares Dämpfungsglied 6 die Einstellung einer relativen Dämpfung zwischen nichtlinearem und linearem Zweig mit Hilfe eines Stellstroms.

In Fig. 2 ist die Addition der Signalvektoren aus dem linearen und nichtlinearen Zweig verdeutlicht. a_out bezeichnet das Ausgangssignal. Die Darstellung normiert die Zeigerlängen auf das Signal im linearen Zweig. Im Vergleich zum Signal im linearen Zweig nimmt in diesem Ausführungsbeispiel das Signal im nichtlinearen Zweig betragsmäßig mit zunehmender Eingangsleistung ab, die Phase dreht im Uhrzeigersinn, d. h. das nichtlineare Element verursacht eine Kompression von Amplitude und Phase. Dadurch nehmen Betrag und Phase des Linearisiererausgangssignals im Vergleich zum Kleinsignalbetrieb zu.

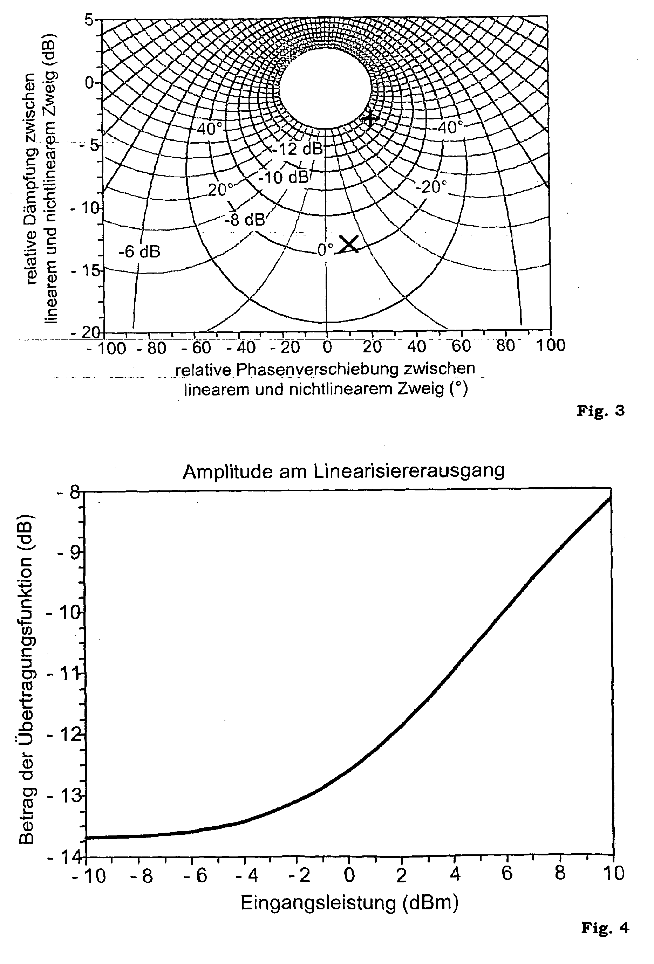

In Fig. 3 sind die Isokonturlinien der Durchgangsdämpfung und der Phasenverschiebung des Linearisiererausgangssignals nach Betrag und Phase veranschaulicht. Die Endpunkte bei minimaler und maximaler Eingangsleistung sind als Kreuze markiert. Dabei entspricht das + dem Betrieb mit minimaler und das X dem Betrieb bei maximaler Eingangsleistung.

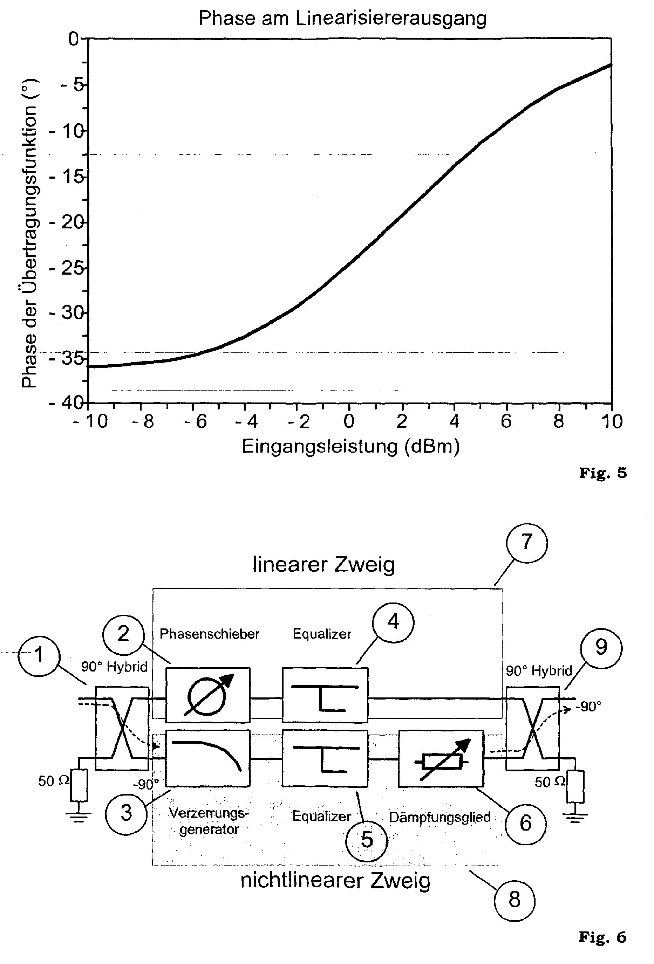

Fig. 3 zeigt, dass mit Variation der Leistung das Isokonturfeld durchschritten wird, so dass sich die in den Fig. 4 und 5 gezeigten Expansionsverläufe nach Betrag und Phase ergeben. Dabei ist in Fig. 4 der Betrag der Übertragungsfunktion des Linearisierers als Funktion der Eingangsleistung dargestellt.

Fig. 5 zeigt die Phase der Übertragungsfunktion des Linearisierers als Funktion der Eingangsleistung.

Fig. 6 zeigt das Blockschaltbild der Linearisiererbrücke nach der erfindungsgemäßen Ausgestaltung mit der zusätzlichen Equalizerstufe im linearen und nichtlinearen Zweig. Diese Equalizerstufe ist von entscheidender Bedeutung für den Abgleich der Linearisiererbrücke. Sowohl im linearen als auch im nichtlinearen Zweig fügt je ein Equalizer 4, 5 einen Frequenzgang in Bezug auf Amplitude und Phase ein. Dadurch können komplexe Übertragungsfunktionen in den beiden Brückenzweigen erzielt werden, die zur gewünschten Expansion hinsichtlich Amplitude und Phase am Ausgang der Lincarisiererschaltung führen und parasitäre Effekte z. B. durch Streukapazitäten und Bondinduktivitäten gezielt kompensieren.

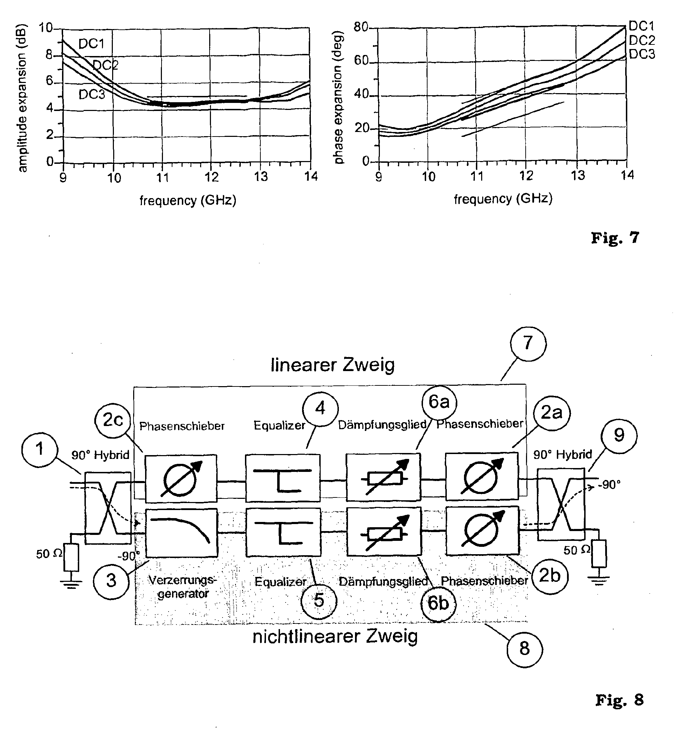

In Fig. 7 ist der Frequenzgang der Amplituden- und Phasenexpansion der Linearisiererbrücke bei maximaler Eingangsleistung im GHz-Bereich dargestellt. Leistungsverstärker haben eine frequenzabhängige Kompressionscharakteristik. Die geforderte Expansionscharakteristik einer typischen KU-Band TWT ist beispielhaft mit Geraden samt Toleranzbereich im Band von 10,7 bis 12,7 GHz markiert.

Der Equalizer 4, 5 fügt einen einstellbaren Frequenzgang in das Übertragungsverhalten des linearen und nichtlinearen Zweigs ein, so dass der Linearisierer beispielsweise eine konstante Amplitudenexpansion und eine über der Frequenz ansteigende Phasenexpansion wie in Fig. 7 aufweist. Der Equalizer 4, 5 erlaubt somit den präzisen Abgleich der Brücke auf die Charakteristik des Leistungsverstärkers. Der Equalizer 4, 5 kann sowohl als passive Schaltung als auch einstellbar mit aktiven Elementen wie beispielsweise Dioden und Transistoren realisiert werden.

In Fig. 8 ist eine weitere Ausgestaltung der Erfindung dargestellt, die im linearen und im nichtlinearen Zweig weitgehend symmetrisch aufgebaut ist. Im linearen Zweig befindet sich ein Phasenschieber 2c, der die Laufzeit durch den Verzerrungsgener ator 3 kompensiert. Je ein Dämpfungsglied 6a und 6b und je ein Phasenschieber 2a und 2b im linearen und nichtlinearen Zweig bilden einen differentiellen Phasenschieber bzw. ein differentielles Dämpfungsglied. Durch den symmetrischen Aufbau erfährt das Signal ähnliche Laufzeitverzögerungen.

Alle in der Beschreibung, den nachfolgenden Ansprüchen und der Zeichnung dargestellten Merkmale können - sowohl einzeln auch in beliebiger Kombination miteinander erfindungswesentlich sein.

### Bezugszahlenliste

- 1: 90° Hybrid
- 2: Phasenschieber
- 2a: Phasenschieber a, symmetrisches Ausführungsbeispiel
- 2b: Phasenschieber b, symmetrisches Ausführungsbeispiel
- 2c: Phasenschieber c, symmetrisches Ausführungsbeispiel
- 3: Verzerrungsgenerator
- 4: erster Equalizer
- 5: zweiter Equalizer
- 6: Dämpfungsglied
- 6a: Dämpfungsglied a, symmetrisches Ausführungsbeispiel
- 6b: Dämpfungsglied b, symmetrisches Ausführungsbeispiel
- 7: linearer Zweig
- 8: nichtlinearer Zweig
- 9: 90° Hybrid

## Patentansprüche

1. Vorverzerrungslinearisierer in Brückentopologie zur Linearisierung von breitbandigen Leistungsverstärkern mit einem Phasenschieber im linearen und einem Verzerrungsgenerator und einem Dämpfungsglied (6) im nichtlinearen Zweig, **dadurch gekennzeichnet, dass** der Linearisierer sowohl im linearen als auch im nichtlinearen Zweig jeweils eine Equalizerstufe (4; 5) besitzt.

2. Vorrichtung nach Anspruch 1, **dadurch gekennzeichnet, dass** die Equalizerstufen (4; 5) dem Abgleich der Linearisiererbrücke dienen.

3. Vorrichtung nach Anspruch 1, **dadurch gekennzeichnet, dass** die Equalizerstufen (4; 5) jeweils in den linearen als auch in den nichtlinearen Zweig einen einstellbaren Frequenzgang einführen.

4. Vorrichtung nach Anspruch 3, **dadurch gekennzeichnet, dass** die Equalizerstufen (4; 5) jeweils in den linearen als auch in den nichtlinearen Zweig eine komplexe, frequenzabhängige lineare Übertragungsfunktion einführen.

5. Vorrichtung nach den Ansprüchen 1, 3 und/oder 4, **dadurch gekennzeichnet, dass** die durch parasitäre Effekte verursachten Frequenzgänge kompensierbar sind.

6. Vorrichtung nach Anspruch 5, **dadurch gekennzeichnet, dass** parasitäre Effekte durch das frequenzabhängige Verhalten aller Brückenkomponenten wie Verzerrungsgenerator, Phasenschieber und Dämpfungsglied gegeben sind.

7. Vorrichtung nach Anspruch 6, **dadurch gekennzeichnet, dass** die durch Streukapazitäten und Verbindungsinduktivitäten verursachten parasitären Effekte kompensierbar sind.

8. Vorrichtung nach einem der vorhergehenden Ansprüche, **dadurch gekennzeichnet, dass** die Equalizerstufen (4; 5) eine über der Frequenz konstante, eine abfallende oder eine ansteigende Amplitudenexpansion und/oder eine abfallende oder ansteigende Phasenexpansion verursachen.

9. Vorrichtung nach Anspruch 8, **dadurch gekennzeichnet, dass** die Equalizerstufen (4; 5) eine zur Linearisierung benötigte Kombination der Frequenzgangtypen der Amplituden- und Phasenexpansion erlauben.

10. Vorrichtung nach einem der vorhergehenden Ansprüche, **dadurch gekennzeichnet, dass** die Equalizerstufen (4; 5) als passive Schaltung ausgestaltet sind.

11. Vorrichtung nach einem der vorhergehenden Ansprüche, **dadurch gekennzeichnet, dass** die Equalizerstufen (4; 5) einstellbar mit aktiven Elementen, wie mit Dioden oder Transistoren, ausgestaltet sind.

12. Verfahren zum Abgleich der Vorrichtung des Anspruchs 1, **dadurch gekennzeichnet, dass** mittels der Equalizerstufen (4; 5) im linearen (7) und nichtlinearen (8) Zweig jeweils der Frequenzgang in Bezug auf Amplitude und Phase angepasst wird.

13. Verfahren nach mindestens einem der vorangegangenen Ansprüche, **dadurch gekennzeichnet, dass** mit dem Verfahren ein Abgleich der Linearisiererbrücke auf die Charakteristik des Leistungsverstärkers erfolgt.

14. Verfahren nach mindestens einem der vorangegangenen Ansprüche, **dadurch gekennzeichnet, dass** das Verfahren mittels einer passiven Schaltung durchgeführt wird.

15. Verfahren nach mindestens einem der vorangegangenen Ansprüche, **dadurch gekennzeichnet, dass** das Verfahren einstellbar mittels aktiver Elemente wie Dioden und/oder Transistoren durchgeführt wird.

## Claims

1. Predistortion linearizer with bridge topology for linearizing broadband power amplifiers having a phase shifter in the linear branch and a distortion generator and an attenuation element (6) in the non-linear branch, **characterized in that** the linearizer has a respective equalizer stage (4; 5) both in the linear branch and in the non-linear branch.

2. Device according to Claim 1, **characterized in that** the equalizer stages (4; 5) serve for balancing the linearizer bridge.

3. Device according to Claim 1, **characterized in that** the equalizer stages (4; 5) respectively introduce an adjustable frequency response into the linear branch and into the non-linear branch.

4. Device according to Claim 3, **characterized in that** the equalizer stages (4; 5) respectively introduce a complex, frequency-dependent linear transfer function into the linear branch and into the non-linear branch.

5. Device according to Claims 1, 3 and/or 4, **characterized in that** the frequency responses caused by parasitic effects can be compensated for.

6. Device according to Claim 5, **characterized in that** parasitic effects result from the frequency-dependent behaviour of all the bridge components such as distortion generator, phase shifter and attenuation element.

7. Device according to Claim 6, **characterized in that** the parasitic effects caused by stray capacitances and bonding inductances can be compensated for.

8. Device according to any of the preceding claims, **characterized in that** the equalizer stages (4; 5) cause an amplitude expansion which, over the frequency, is constant, decreases or increases, and/or a decreasing or increasing phase expansion.

9. Device according to Claim 8, **characterized in that** the equalizer stages (4; 5) allow a combination of the frequency response types of the amplitude expansion and phase expansion, said combination being required for linearization.

10. Device according to any of the preceding claims, **characterized in that** the equalizer stages (4; 5) are configured as a passive circuit.

11. Device according to any of the preceding claims, **characterized in that** the equalizer stages (4; 5) are configured in an adjustable fashion with active elements, such as with diodes or transistors.

12. Method for balancing the device of Claim 1, **characterized in that** by means of the equalizer stages (4; 5), in the linear branch (7) and non-linear branch (8), the frequency response is in each case adapted with regard to amplitude and phase.

13. Method according to at least one of the preceding claims, **characterized in that** the linearizer bridge is balanced to the characteristic of the power amplifier by means of the method.

14. Method according to at least one of the preceding claims, **characterized in that** the method is carried out by means of a passive circuit.

15. Method according to at least one of the preceding claims, **characterized in that** the method is carried out in an adjustable fashion by means of active elements such as diodes and/or transistors.

## Revendications

1. Linéariseur à prédistorsion dans la topologie des ponts pour linéariser des amplificateurs de puissance à large bande avec un déphaseur en branche linéaire et un générateur de distorsion et un atténuateur (6) en branche non linéaire **caractérisé en ce que** le linéariseur possède à chaque fois un étage égaliseur (4, 5) tant dans la branche linéaire que dans la branche non linéaire.

2. Dispositif selon la revendication 1 **caractérisé en ce que** les étages égaliseurs (4, 5) servent à l'équilibrage du pont de linéariseur.

3. Dispositif selon la revendication 1 **caractérisé en ce que** les étages égaliseurs (4, 5) introduisent à chaque fois une réponse en fréquence réglable tant dans la branche linéaire que dans la branche non linéaire.

4. Dispositif selon la revendication 3 **caractérisé en ce que** les étages égaliseurs (4, 5) introduisent à chaque fois une fonction de transmission linéaire, complexe, en fonction de la fréquence tant dans la branche linéaire que dans la branche non linéaire.

5. Dispositif selon les revendications 3 et/ou 4 **caractérisé en ce que** les réponses en fréquence causées par des effets parasites sont compensables.

6. Dispositif selon la revendication 5 **caractérisé en ce que** les effets parasites sont causés par le comportement dépendant de la fréquence de tous les composants de pont comme le générateur de distorsion, le déphaseur et l'atténuateur.

7. Dispositif selon la revendication 6 **caractérisé en ce que** les effets parasites causés par des capacités de dispersion et des inductivités de liaison sont compensables.

8. Dispositif selon une quelconque des revendications précédentes **caractérisé en ce que** les étages égaliseurs (4, 5)causent une expansion d'amplitude constante au-dessus de la fréquence, décroissante ou croissante et/ou une expansion de phase décroissante ou croissante.

9. Dispositif selon la revendication 8 **caractérisé en ce que** les étages égaliseurs (4,5) permettent une combinaison nécessaire à la linéarisation des types de réponse en fréquence de l'expansion d'amplitude et de phase.

10. Dispositif selon une quelconque des revendications précédentes **caractérisé en ce que** les étages égaliseurs (4, 5) sont constitués comme circuit passif.

11. Dispositif selon une quelconque des revendications précédentes **caractérisé en ce que** les étages égaliseurs (4, 5) sont constitués réglables avec des éléments actifs, comme avec des diodes ou des transistors.

12. Procédé pour équilibrage du dispositif selon la revendication 1 **caractérisé en ce qu'**au moyen des étages égaliseurs (4, 5) à chaque fois dans la branche linéaire (7) et non linéaire (8) la réponse en fréquence est adaptée en référence à l'amplitude et à la phase.

13. Procédé selon au moins une quelconque des revendications précédentes **caractérisé en ce qu'**avec le procédé un équilibrage du pont de linéariseur a lieu sur la caractéristique de l'amplificateur de puissance.

14. Procédé selon au moins une quelconque des revendications précédentes **caractérisé en ce que** le procédé est réalisé au moyen d'un circuit passif.

15. Procédé selon au moins une quelconque des revendications précédentes **caractérisé en ce que** le procédé est réalisé réglable au moyen d'éléments actifs comme des diodes et/ou des transistors.
